# EUROPEAN PATENT APPLICATION

(11) **EP 4 682 570 A1**
(43) Date of publication of application: **21.01.2026**
(21) Application number: 24192640.1
(22) Date of filing: 02.08.2024
(51) Int. Cl.: G01R 33/38, G01R 33/3815, G01R 33/421

(54) **COOLING BRACKETS FOR SUPERCONDUCTING MAGNETS AND A MAGNETIC RESONANCE IMAGING DEVICE HAVING THE COOLING BRACKETS**

(30) Priority: 17.07.2024 US 202463672287 P
(71) Applicant: Koninklijke Philips N.V., 5656 AG Eindhoven (NL)
(72) Inventor: VERNICKEL, Peter, Eindhoven (NL); FORTHMANN, Peter, Eindhoven (NL); LIPS, Oliver, 5656AG Eindhoven (NL)
(74) Representative: Philips Intellectual Property & Standards

(57) **Abstract**

A magnetic resonance imaging device (100) is described, including: an electrically superconducting coil (203); a rim (204) disposed around all but one side of the electrically superconducting coil (203). The rim (204) includes a material with a thermal conductivity in the range of approximately 300 W/m/K to approximately 10000 W/m/K. The device (100) also includes a bracket (201) disposed over the one side of the electrically superconducting coil (203); and a lid (202) disposed over the bracket (201). The rim (204) and the lid (202) are adapted to shield the electrically superconducting coil (203) from non-stationary stray magnetic fields and conduct heat generated in the device (100) away from the electrically superconducting coil (203).

## Description

### BACKGROUND

Magnetic Resonance Imaging (MRI) devices comprise superconducting magnets used to generate the DC magnetic fields needed for (magnetic resonance) MR imaging. Typical MR magnets comprise main coils and shield coils, with the main coils adapted to generate the main magnetic field and the shield coils adapted to shield the MRI device from stray fields often generated by gradient coils of the MRI device.

In operation, the MR magnets generate Lorenz forces, which are typically radial forces. A coil consist of several windings of superconducting wire. The winding pattern of such a coil is a compromise of high fill factor, electrical insulation between windings, thermal conductivity of the combined material, and mechanical stability. Magnetic forces are directed so that individual windings repel each other when current is applied. These radial forces are exerted on the magnet structure and cause so-called hoop stresses. Hoop stress is proportional to magnetic field density, current density, and the radius of the coil. Often a technique known as overbanding is used, with wire layers of suitable material (e.g., stainless-steel) disposed around the coils of the superconducting magnet to provide a stabilizing force to the radial hoop stresses. These so-called hoop stresses can be so large that they damage the coil.

In addition to hoop stresses, known superconducting magnets are susceptible to reduced performance caused by heat, which can deleteriously impact their operation. In addition to ambient heat, eddy currents created by the gradient coils can add unwanted heat to the MR magnet. Certain known MRI devices use a so-called cooling bath, in which the superconducting coils are immersed, which comprises a cooling material such as helium, to remove heat generated. Cooling using a cooling bath adds to the complexity and the cost of production and maintenance of MRI devices.

What is needed, therefore, is a medical device that provides protection from hoop stress and dissipation of heat generated by various sources in MR magnets and MRI devices that overcomes at least the noted drawbacks of the known approaches described above.

### SUMMARY

In accordance with a representative embodiment, an apparatus, comprises: an electrically superconducting coil; a rim disposed around all but one side of the electrically superconducting coil, the rim comprising a material with a thermal conductivity in the range of approximately 300 W/m/K to approximately 10000 W/m/K; a bracket disposed over the one side of the electrically superconducting coil; and a lid disposed over the bracket. The rim and the lid are adapted to shield the electrically superconducting coil from non-stationary stray magnetic fields (i.e. gradient-induced eddy currents) and conduct heat generated in the apparatus away from the superconducting coil.

In accordance with another representative embodiment, a magnetic resonance imaging (MRI) device, comprises: an electrically superconducting coil; a rim disposed around all but one side of the electrically superconducting coil, the rim comprising a material with a thermal conductivity in the range of approximately 300 W/m/K to approximately 10000 W/m/K; a bracket disposed over the one side of the electrically superconducting coil; and a lid disposed over the bracket, wherein the rim and the lid are adapted to shield the electrically superconducting coil from non-stationary stray magnetic fields and conduct heat generated in the MRI device away from the superconducting coil.

### BRIEF DESCRIPTION OF THE DRAWINGS

The example embodiments are best understood from the following detailed description when read with the accompanying drawing figures. It is emphasized that the various features are not necessarily drawn to scale. In fact, the dimensions may be arbitrarily increased or decreased for clarity of discussion. Wherever applicable and practical, like reference numerals refer to like elements.
Fig. 1 is a perspective view of a magnetic resonance imaging (MRI) system in accordance with a representative embodiment.
Fig. 2A is a cross-sectional view of a superconducting magnet system which may be employed in an MRI apparatus according to a representative embodiment.
Fig. 2B is a cross-sectional view of the superconducting magnet system of Fig. 2A.
Fig. 3A is a cross-sectional view of a superconducting magnet system which may be employed in an MRI apparatus according to a representative embodiment.
Fig. 3B is a perspective view showing the plane of cross-section of the superconducting magnet system of Fig. 3A.
Fig. 4A is a cross-sectional view of a superconducting magnet system which may be employed in an MRI apparatus according to a representative embodiment.
Fig. 4B is a perspective view showing the plane of cross-section of the superconducting magnet system of Fig. 4A.

### DETAILED DESCRIPTION

In the following detailed description, for the purposes of explanation and not limitation, representative embodiments disclosing specific details are set forth in order to provide a thorough understanding of embodiments according to the present teachings. However, other embodiments consistent with the present disclosure that depart from specific details disclosed herein remain within the scope of the appended claims. Descriptions of known systems, devices, materials, methods of operation and methods of manufacture may be omitted so as to avoid obscuring the description of the representative embodiments. Nonetheless, systems, devices, materials and methods that are within the purview of one of ordinary skill in the art are within the scope of the present teachings and may be used in accordance with the representative embodiments. It is to be understood that the terminology used herein is for purposes of describing particular embodiments only and is not intended to be limiting. Definitions and explanations for terms herein are in addition to the technical and scientific meanings of the terms as commonly understood and accepted in the technical field of the present teachings.

It will be understood that, although the terms first, second, third etc. may be used herein to describe various elements or components, these elements or components should not be limited by these terms. These terms are only used to distinguish one element or component from another element or component. Thus, a first element or component discussed below could be termed a second element or component without departing from the teachings of the inventive concept.

As used in the specification and appended claims, the singular forms of terms 'a', 'an' and 'the' are intended to include both singular and plural forms, unless the context clearly dictates otherwise. Additionally, the terms "comprises," and/or "comprising," and/or similar terms when used in this specification, specify the presence of stated features, elements, and/or components, but do not preclude the presence or addition of one or more other features, elements, components, and/or groups thereof. As used herein, the term "and/or" includes any and all combinations of one or more of the associated listed items.

Unless otherwise noted, when an element or component is said to be "connected to", "coupled to", or "adjacent to" another element or component, it will be understood that the element or component can be directly connected or coupled to the other element or component, or intervening elements or components may be present. That is, these and similar terms encompass cases where one or more intermediate elements or components may be employed to connect two elements or components. However, when an element or component is said to be "directly connected" or "immediately adjacent" to another element or component, this encompasses only cases where the two elements or components are connected or disposed immediately adjacent to each other without any intermediate or intervening elements or components.

Unless otherwise noted, when something is said to have approximately a certain value, then it means that it is within 10% of that value. As used herein, "substantially removes heat" means approximately 0.5 W to approximately 2 W for a superconducting magnet at 4 K and approximately 1W to approximately 5W for a superconducting magnet at 20 K.

As described herein in connection with various representative embodiments, the present teachings relate to a structure adapted for use in an MR apparatus that provides both shielding of superconducting coils (both shield coils and main coils) from eddy current generated by the gradient coil, as well as improved heat dissipation from not only the generated eddy currents but also from the ambient. As described more fully below, the structure comprises a rim and a lid, each comprising a material with a thermal conductivity in the range of approximately 300 W/m/K to approximately 10000 W/m/K. The rim and the lid are then connected to a thermal busbar (heat sink) that conducts the heat away from the superconducting coils. Furthermore, when energized superconducting coils expand radially, the structure comprises a bracket that extends around the superconducting coils to provide structural support. Notably, the use of stainless steel for the bracket is merely illustrative, and other materials within the purview of the ordinarily skilled artisan are contemplated. These materials include, but are not limited to Titanium, Tungsten, Chromium and Vanadium. Aluminum can also be used for moderate forces when liberally applied.

As described more fully below, the bracket provides a responsive radial force to counter the radial force caused by the superconducting coils during expansion. Because of the arrangement of the various components of the structure, the bracket causes the rim and the lid to be pressed firmly against the superconducting coils, which further improves the ability of the components of the structure to dissipate heat. Because of the structure of the superconducting magnets of the various representative embodiments, improved heat dissipation enables operation at so-called high-temperature superconduction (e.g., 20 K-250 K) while mitigating hoop stress that occurs when the superconducting coils are energized. This improvement to MRI devices enables the deployment of superconducting coils that are not emersed completely in a cooling bath (e.g., a Helium cooling bath). Rather, the superconducting coils of the present teaches are contemplated for use at high-temperature superconduction without any cooling material, or with cooling without complete emersion in a cooling bath.

Rather, heat dissipation is effected using the rim and lid structure of the present teachings alone, or in combination with so-called blue seal structures commercially available from Koninklijke Philips, N.V. As is known, blue seal structures are an alternative to bath cooling in which cooling may be done using fully conduction cooling using heat pipes or thermosiphons. Here, a cooling medium like helium is used to transport heat and supply some thermal mass. The cooling material is typically enclosed and guided in tubular structures (not shown), from the refrigerator to the regions that need to be cooled. Gravity and appropriate layout enable circulation of the refrigerant.

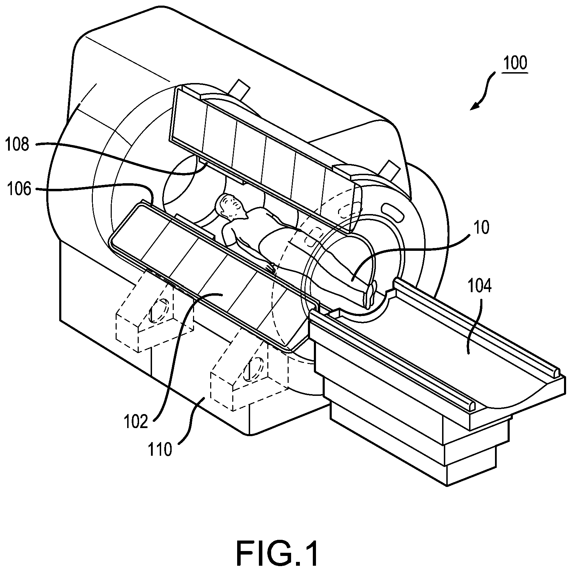

Fig. 1 is a perspective view of a magnetic resonance imaging (MRI) device 100 of a representative embodiment. The MRI device 100 comprises a superconducting magnet apparatus 102; a patient table 104 configured to hold a patient 10; gradient coils 106 configured to at least partially surround at least a portion of patient 10 for which MRI device 100 generates an image; a radio frequency coil 108 configured to apply a radio frequency signal to at least the portion of patient 10 which is being imaged, and to alter the alignment of the magnetic field. The general operation of an MRI device is known and many aspects of the MRI device are not repeated herein.

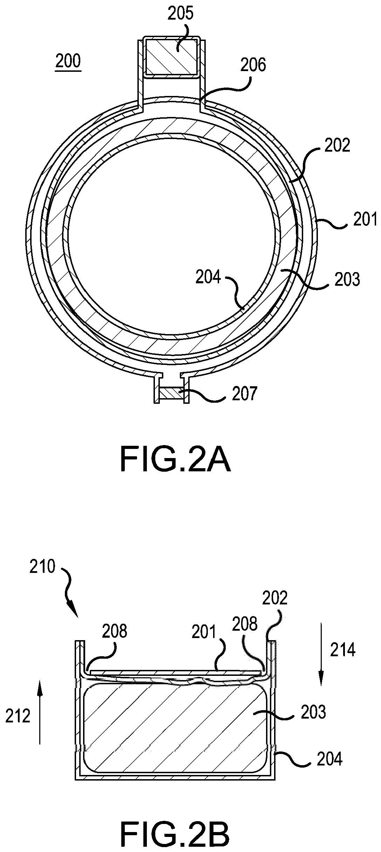

Fig. 2A is a cross-sectional view of a superconducting magnet apparatus 200 in accordance with a representative embodiment. The superconducting magnet apparatus 200 is adapted to be used in the MRI device 100, and comprises a bracket 201 disposed over the one side of an electrically superconducting coil 203. Notably, the electrically superconducting coil is one coil of the superconducting magnet apparatus 200 of the superconducting magnet apparatus 200 that is adapted for use in MRI device 100, and may be a main coil or a shield coil. As will be appreciated by one of ordinary skill in the art, the superconducting magnet apparatus 200 of the MRI device 100 comprises a plurality of superconducting coils.

The structure of Fig. 2A shows the arrangement of various components of a representative embodiment around one such superconducting coil. Similar arrangements of the various components that comprise the superconducting magnet apparatus 200 are provided at other locations of superconducting coils such as electrically superconducting coil 203.

The superconducting magnet apparatus 200 comprises a lid 202 disposed over one side of the electrically superconducting coil 203, and a rim 204 is disposed around all but the side of the electrically superconducting coil 203 over which the lid 202 is disposed. As described more fully below, the lid 202 and the rim 204 not only shield the electrically superconducting coil 203 from eddy currents generated therein by external source (e.g., the gradient coil), but also dissipate heat generated by the eddy currents, and ambient heat from other sources away from the electrically superconducting coil 203. As shown, the lid 202 contacts a thermal busbar 205, which diverts heat energy to a heat sink (not shown) for the MRI device 100.

In accordance with a representative embodiment, the lid 202 and the rim 204 comprise a material having a thermal conductivity in the range of approximately 300 W/m/K to approximately 10000 W/m/K. In certain representative embodiments, the lid 202 and the rim 204 comprise oxygen-free high-conductivity (OFHC) copper. In other representative embodiments the lid 202 and the rim 204 comprise copper. In certain representative embodiments, the rim 204, or the lid 202, or both may be braid comprising strands of the selected material (e.g., braided copper), which usefully enables the connections to a thermal busbar 205 through an opening 206 in the bracket 201. In other representative embodiments, the lid 202 or the rim 204 may comprise another structure, such as a sheet or layer of the selected material used to dissipate heat to the thermal busbar 205. Just by way of illustration, the sheet or layer comprises copper having a thickness on the order of approximately 1 mm to approximately 5 mm.

The bracket 201 is fastened at 207 to provide the structural reinforcement as noted above. The bracket 201 illustratively comprises stainless-steel, although as noted above, other materials are contemplated for use as the bracket 201. The bracket 201 may comprise one or more cylindrical layers, with openings therein to enable thermal connection to the lid 202 and rim 204 as described more fully below. The bracket 201 may also comprise one or more of the materials noted above. Moreover, instead of being one piece of sheet metal, the bracket may comprise multiple layers of thinner sheets of the same or even different materials, where the thickness would be on the order of approximately 1 mm to approximately 5 mm. In this manner thick and strong brackets can be made that are still easy to bend for forming. Furthermore, the bracket 201 may comprise a structure such as described in commonly owned U.S. Patent 10,365,338 to Jonas, et al., the entire disclosure of which is specifically incorporated herein by reference. Accordingly, instead of overbanding windings of aluminum or stainless-steel, the various representative embodiments include bracket 201 to counteract magnetic hoop stress. During manufacturing, the stainless-steel brackets are put tightly onto the windings, thus establishing good contact of the lid 202 and the rim 204 to the surface of the electrically superconducting coil 203. Additional grease can be applied for improved thermal coupling.

Fig. 2B is a cross-sectional view of a portion 210 of the superconducting magnet system of Fig. 2A. Various details and aspects of the presently described representative embodiment are common to those described in connection with the description of the superconducting magnet apparatus 200 of Fig. 2A. These common details and aspects may not be repeated to avoid obscuring the presently described representative embodiment.

The section view of the portion 210 shows bracket 201 disposed over the lid 202, which is disposed over one side of the electrically superconducting coil 203. The rim 204 is disposed around all but the side of the electrically superconducting coil 203 over which the lid 202 is disposed. Bracket 201 is disposed over the one side of an electrically superconducting coil 203.

As alluded to above, openings 208 are provided in the bracket 201 to allow portions of the lid 202 to be connected to the thermal busbar 205 (not shown in Fig. 2B). Notably, rather than providing openings in the bracket 201, for easier application, the lid 202 and rim 204 can be added to the bracket 201 in the form of a liner comprising layers of the respective materials for the lid 202 and the rim 204 noted above.

As more readily seen in Fig. 2B, because of the arrangement of the various components of the structure, expansion of the electrically superconducting coil causes a force 212 to exist. By the present teachings, the bracket 201 exerts a reactionary force 214 as shown. As such, when the electrically superconducting coil expands radially (see Fig. 2A), the restraint of the bracket 201 causes the rim 204 and the lid 202 to be pressed firmly against the electrically superconducting coil 203, which further improves the ability of the components of the structure to dissipate heat. As noted above, because of the structure of the superconducting magnets of the various representative embodiments, improved heat dissipation enables operation at so-called high-temperature superconduction (e.g., 20 K-250 K) while mitigating hoop stress that occurs when the electrically superconducting coils are energized. This improvement to MRI devices enables the deployment of electrically superconducting coils that are not emersed completely in a cooling bath (e.g., a Helium cooling bath). Rather, the electrically superconducting coils of the present teaches are contemplated for use at high-temperature superconduction without any cooling material, or with cooling without complete emersion in a cooling bath (e.g., in a blue seal structure noted above).

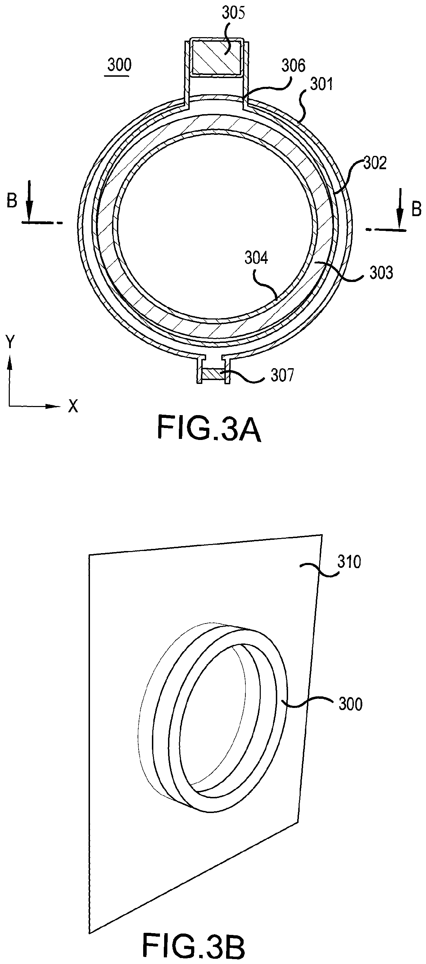

Fig. 3A is a cross-sectional view of a superconducting magnet apparatus 300 in accordance with a representative. Various details and aspects of the presently described representative embodiment are common to those described in connection with the description of the superconducting magnet apparatus 200 of Fig. 2A. Fig. 3A shows plane of cross-section (x-y plane in the coordinate system shown). The plane of cross-section 310 of the superconducting magnet apparatus 300 is shown in Fig. 3B.

The superconducting magnet apparatus 300 is adapted to be used in the MRI device 100, and comprises a bracket 301 disposed over the one side of an electrically superconducting coil 303. Notably, the electrically superconducting coil 303 is one coil of the superconducting magnet apparatus 300 of the superconducting magnet apparatus 300 that is adapted for use in MRI device 100, and may be a main coil or a shield coil. As will be appreciated by one of ordinary skill in the art, the superconducting magnet apparatus 300 of the MRI device 100 comprises a plurality of electrically superconducting coils.

The structure of Fig. 3A shows the arrangement of various components of a representative embodiment around one such electrically superconducting coil. Similar arrangements of the various components that comprise the superconducting magnet apparatus 300 are provided at other locations of electrically superconducting coils such as electrically superconducting coil 303.

The superconducting magnet apparatus 300 comprises a lid 302 disposed over one side of the electrically superconducting coil 303, and a rim 304 is disposed around all but the side of the electrically superconducting coil 303 over which the lid 302 is disposed. As described more fully below, the lid 302 and the rim 304 not only shield the electrically superconducting coil 303 from eddy currents generated therein by external source (e.g., the gradient coil), but also dissipate heat generated by the eddy currents, and ambient heat from other sources away from the electrically superconducting coil 303. As shown, the lid 302 contacts a thermal busbar 305, which diverts heat energy to a heat sink (not shown) for the MRI device 100.

In accordance with a representative embodiment, the lid 302 and the rim 304 comprise a material having a thermal conductivity in the range of approximately 300 W/m/K to approximately 10000 W/m/K. In certain representative embodiments, the lid 302 and the rim 304 comprise oxygen-free high-conductivity (OFHC) copper. In other representative embodiments the lid 302 and the rim 304 comprise copper. In certain representative embodiments, the rim 304, or the lid 302, or both may be braid comprising strands of the selected material (e.g., braided copper), which usefully enables the connections to a thermal busbar 305 through an opening 306 in the bracket 301. In other representative embodiments, the lid 302 or the rim 304 may comprise another structure, such as a sheet or layer of the selected material used to dissipate heat to the thermal busbar 305. Notably, providing a sheet/layer of the materials and dimensions noted above is useful in conducting heat away from the coils while maintaining temperature gradients of approximately 1K to approximately 2K between the coil and the thermal busbar 305. Notably, the heat conduction achieved by the various representative embodiments in on the order of approximately 1 W.

The bracket 301 is fastened at 307 to provide the structural reinforcement as noted above. The bracket 301 illustratively comprises stainless-steel, although as noted above, other materials are contemplated for use as the bracket 301. The bracket 301 may comprise one or more cylindrical layers, with openings therein to enable thermal connection to the lid 302 and rim 304 as described more fully above. The bracket 301 may comprise one or more cylindrical layers, with openings therein to enable thermal connection to the lid 302 and rim 304 as described more fully below. The bracket 301 may also comprise one or more of the materials noted above. Moreover, instead of being one piece of sheet metal, the bracket may comprise multiple layers of thinner sheets of the same or even different materials, where the thickness would be on the order of approximately 1mm to approximately 5 mm. In this manner thick and strong brackets can be made that are still easy to bend for forming. Moreover, the bracket 301 may comprise a structure such as described in commonly owned U.S. Patent 10,365,338 to Jonas, et al., the entire disclosure of which is specifically incorporated herein by reference. Accordingly, instead of overbanding windings of aluminum or stainless-steel, the various representative embodiments include bracket 301 to counteract magnetic hoop stress. During manufacturing, the stainless-steel brackets are put tightly onto the windings, thus establishing good contact of the lid 302 and the rim 304 to the surface of the electrically superconducting coil 303. Additional grease can be applied for improved thermal coupling.

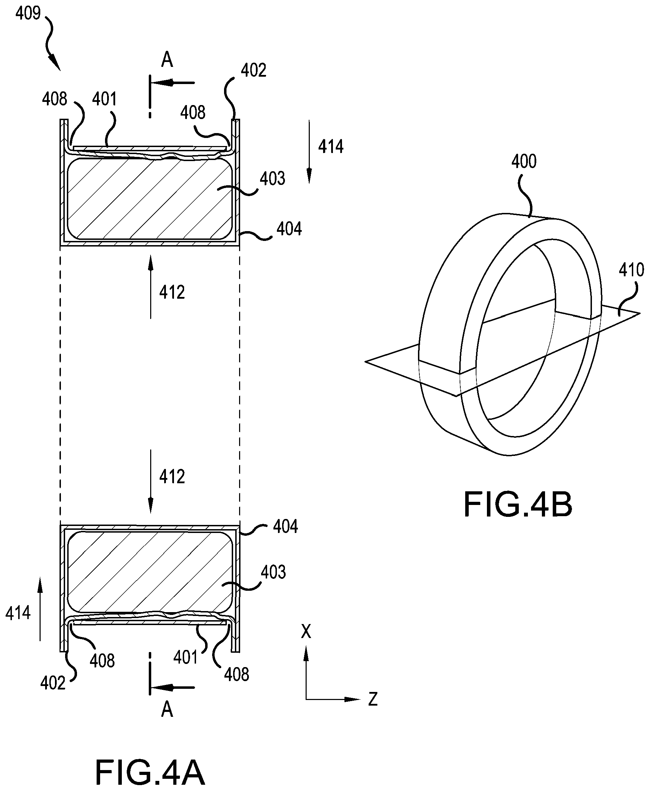

Fig. 4A is a cross-sectional view of a portion 409 of the superconducting magnet system of Figs. 2A and 3A. Various details and aspects of the presently described representative embodiment are common to those described in connection with the description of the superconducting magnet apparatus 200, 300 of Figs. 2A~3A. These common details and aspects may not be repeated to avoid obscuring the presently described representative embodiment.

Fig. 4A shows plane of cross-section (x-y plane in the coordinate system shown). The plane of cross-section 410 of the superconducting magnet apparatus 400 is shown in Fig. 4B.

The section view of the portion 409 shows bracket 401 disposed over the lid 402, which is disposed over one side of the electrically superconducting coil 403. The rim 404 is disposed around all but the side of the electrically superconducting coil 403 over which the lid 402 is disposed. Bracket 401 is disposed over the one side of an electrically superconducting coil 403.

As alluded to above, openings 408 are provided in the bracket 401 to allow portions of the lid 402 to be connected to the thermal busbar 405 (not shown in Fig. 4A). Notably, rather than providing openings in the bracket 401, for easier application, the lid 402 and rim 404 can be added to the bracket 401 in the form of a liner comprising layers of the respective materials for the lid 402 and the rim 404 noted above.

As more readily seen in Fig. 4A, because of the arrangement of the various components of the structure, expansion of the electrically superconducting coil causes a force 412 to exist. By the present teachings, the bracket 401 exerts a reactionary force 414 as shown. As such, when the electrically superconducting coil expands radially (see Figs. 2A, 3A), the restraint of the bracket 401 causes the rim 404 and the lid 402 to be pressed firmly against the electrically superconducting coil 403, which further improves the ability of the components of the structure to dissipate heat. As noted above, because of the structure of the superconducting magnets of the various representative embodiments, improved heat dissipation enables operation at so-called high-temperature superconduction (e.g., 20 K-250 K) while mitigating hoop stress that occurs when the electrically superconducting coils are energized. This improvement to MRI devices enables the deployment of electrically superconducting coils that are not emersed completely in a cooling bath (e.g., a Helium cooling bath). Rather, the electrically superconducting coils of the present teaches are contemplated for use at high-temperature superconduction without any cooling material, or with cooling without complete emersion in a cooling bath (e.g., in a blue seal structure noted above).

One or more embodiments of the disclosure may be referred to herein, individually and/or collectively, by the term "invention" merely for convenience and without intending to voluntarily limit the scope of this application to any particular invention or inventive concept. Moreover, although specific embodiments have been illustrated and described herein, it should be appreciated that any subsequent arrangement designed to achieve the same or similar purpose may be substituted for the specific embodiments shown. This disclosure is intended to cover any and all subsequent adaptations or variations of various embodiments. Combinations of the above embodiments, and other embodiments not specifically described herein, will be apparent to those of skill in the art upon reviewing the description.

The Abstract of the Disclosure is provided to comply with 37 C.F.R. § 1.72(b) and is submitted with the understanding that it will not be used to interpret or limit the scope or meaning of the claims. In addition, in the foregoing Detailed Description, various features may be grouped together or described in a single embodiment for the purpose of streamlining the disclosure. This disclosure is not to be interpreted as reflecting an intention that the claimed embodiments require more features than are expressly recited in each claim. Rather, as the following claims reflect, inventive subject matter may be directed to less than all of the features of any of the disclosed embodiments. Thus, the following claims are incorporated into the Detailed Description, with each claim standing on its own as defining separately claimed subject matter.

The preceding description of the disclosed embodiments is provided to enable any person skilled in the art to practice the concepts described in the present disclosure. As such, the above disclosed subject matter is to be considered illustrative, and not restrictive, and the appended claims are intended to cover all such modifications, enhancements, and other embodiments which fall within the true spirit and scope of the present disclosure. Thus, to the maximum extent allowed by law, the scope of the present disclosure is to be determined by the broadest permissible interpretation of the following claims and their equivalents and shall not be restricted or limited by the foregoing detailed description.

## Claims

1. A superconducting magnet apparatus (102), comprising:
an electrically superconducting coil (203);
a rim (204) disposed around all but one side of the electrically superconducting coil (203), the rim (204) comprising a material with a thermal conductivity in the range of approximately 300 W/m/K to approximately 10000 W/m/K;
a bracket (201) disposed over the one side of the electrically superconducting coil (203); and
a lid (202) disposed at least partially between the bracket (201) and the electrically superconducting coil, wherein the rim (204) and the lid (202) are adapted to shield the electrically superconducting coil (203) from stray magnetic fields and dissipate heat.

2. The apparatus of claim 1, wherein the material has a thermal conductivity in the range of approximately 300 W/m/K to approximately 2000 W/m/K.

3. The apparatus of claim 1 or 2, wherein openings (208) exist in the bracket (201) and a portion (210) of the lid (202) is adapted to pass through the openings (208).

4. The apparatus of any of the preceding claims, wherein the portion (210) of the lid (202) is connected to a thermal sink to remove heat from the electrically superconducting coil (203), the rim (204) and the lid (202).

5. The apparatus of any of the preceding claims, wherein the connection to the thermal sink substantially removes the heat generated by the eddy currents due to stray magnetic fields.

6. The apparatus of any of the preceding claims, wherein the lid (202) comprises a copper braid.

7. The apparatus of any of the claims 1 to 5, wherein the lid (202) comprises a sheet of copper.

8. The apparatus of any of the preceding claims, wherein the rim (204) comprises copper.

9. The apparatus of claim 6, wherein the copper braid comprises oxygen-free high-conductivity (OFHC) copper.

10. The apparatus of any of the preceding claims, wherein the superconducting coil comprises a high-critical temperature, high T_{c}, superconducting coil.

11. The apparatus of claim 10, wherein the high T_{c} superconducting coil is adapted to operate at a temperature in the range of approximately 20 Kelvin to approximately 250 Kelvin.

12. The apparatus of claim 10, wherein the high T_{c} superconducting coil is adapted to operate at a temperature in the range of approximately 20 Kelvin to approximately 100 Kelvin.

13. A magnetic resonance imaging device comprising a superconducting magnet apparatus according to any of the claims 1 to 12.

14. A method of manufacturing a superconducting magnetic apparatus, comprising:
providing an electrically superconducting coil (203);
providing a rim (204) disposed around all but one side of the electrically superconducting coil (203), the rim (204) comprising a material with a thermal conductivity in the range of approximately 300 W/m/K to approximately 10000 W/m/K;
providing a lid (202) disposed at least partially over the one side of the electrically superconducting coil (203);
providing a bracket (201) disposed at least partially over the lid (202), wherein the rim (204) and the lid (202) are adapted to shield the electrically superconducting coil (203) from stray magnetic fields and dissipate heat.

15. A magnetic resonance imaging, MRI, device (100), comprising:
an electrically superconducting coil (203);
a rim (204) disposed around all but one side of the electrically superconducting coil (203), the rim (204) comprising a material with a thermal conductivity in the range of approximately 300W/m/K to approximately 10000 W/m/K;
a bracket (201) disposed over the one side of the electrically superconducting coil (203); and
a lid (202) disposed beneath the bracket (201), wherein the rim (204) and the lid (202) are adapted to shield the electrically superconducting coil (203) from stray magnetic fields and dissipate heat generated in the MRI device (100).
